# EUROPÄISCHE PATENTANMELDUNG

(11) **EP 1 902 807 A1**
(43) Veröffentlichungstag der Anmeldung: **26.03.2008**
(21) Anmeldenummer: 06020522.6
(22) Anmeldetag: 29.09.2006
(51) Int. Cl.: B23K 1/015, B23K 1/00, B23K 3/04, H05K 3/34, B23K 101/42

(54) **Lötverfahren und Vorrichtung zum Dampfphasenlöten mit einer gesteuerten Dampfphasen-Material-Aufbringvorrichtung**

(30) Priorität: 20.09.2006 DE 102006044045
(71) Anmelder: Linde Aktiengesellschaft, 80807 München (DE)
(72) Erfinder: Wandke, Ernst, Dr., 82538 Geretsried (DE)

(57) **Zusammenfassung**

Die Erfindung betrifft ein Verfahren zum Dampfphasenlöten mit einer Vorwärm- und einer Lötphase, wobei in der Vorwärm- und/oder Lötphase ein Dampfphasenmaterial als Dampf oder als Dampf-Gas-Gemisch auf eine Leiterplatte (1) oder auf andere zu Iötende Baugruppen gesteuert aufgebracht wird. Desweiteren betrifft die Erfindung eine Vorrichtung zum Dampfphasenlöten mit einer Vorwärm- und einer Lötzone, wobei eine Aufbrmngvorrichtung (2a,2b,2c) zum gesteuerten Aufbringen eines Dampfphasen-Materials auf eine Leiterplatte (1) oder auf andere zu lötende Baugruppen vorgesehen ist.

## Beschreibung

Die vorliegende Erfindung betrifft ein Verfahren zum Dampfphasenlöten mit einer Vorwärm- und einer Lötphase sowie eine Vorrichtung zum Dampfphasenlöten mit einer Vorwärm- und einer Lötzone.

Das Dampfphasenlöten ist ein Lötverfahren aus der Gruppe der Reflow-Lötverfahren, bei denen eine bereits auf das zu lötende Bauteil aufgebrachte Lotpaste durch Erwärmen wieder verflüssigt wird und dadurch die gewünschten Kontakte hergestellt werden. Das Dampfphasenlöten ist insbesondere zum Simultanlöten von elektrischen Bauelementen auf Leiterplatten oder von verschiedenen elektrischen und/oder mechanischen Bauteilen unterschiedlichster Funktion und Größe geeignet.

Für das bekannte Dampfphasenlöten ist es charakteristisch, dass ein verdampftes Medium, das sog. Dampfphasen-Material, auf eine zum Löten fertig mit Lotpaste bedruckte und bestückte Leiterplatte, die eine Ausgangstemperatur unter dem Kondensationspunkt des Dampfphasen-Materials aufweist, aufkondensiert wird, wobei die Leiterplatte hauptsächlich durch die dabei frei werdende Kondensationswärme auf Löttemperatur aufgeheizt wird. Durch die Kondensation bildet sich eine mehr oder weniger gleichmäßig dicke Flüssigkeitsschicht aus, die gleichzeitig den Luftsauerstoff von der Leiterplatte abschirmt und somit die Leiterplatte inertisiert. Dies führt aber auch dazu, dass Bauteilen mit großer Oberfläche mehr Energie in Form von Kondensationswärme zugeführt wird als Bauteilen mit kleinerer Oberfläche.

Das bekannte Verfahren ist vorteilhaft, weil z.B. eine Überhitzung der Leiterplatten nicht möglich ist, da der Kondensationspunkt die Obergrenze der auf die Leiterplatte einwirkenden Temperatur darstellt und in der Regel eine sehr gleichmäßige Temperaturverteilung erzielt wird.

Das bekannte Verfahren wird in der Praxis in verschiedenen Varianten durchgeführt. Bei der verbreitetsten und einfachsten Variante wird die Leiterplatte in die Dampfphase eines entsprechend erhitzten Materials getaucht. Die auch hier notwendige Vorheizung wird durch einen entsprechend langen Aufenthalt der Leiterplatte im Phasengrenzbereich oder bereits vorher extern, z.B. über eine externe Heizeinrichtung, aufgebracht. Eine andere Möglichkeit zur Vorwärmung der Leiterplatte bietet sich durch Verdampfen von Dampfphasen-Material in der Vorwärmzone, z.B. mit Hilfe einer Heizplatte. Als Dampfphasen-Material kommen in der Regel Kohlenwasserstoffe, meist auf Siliziumbasis, zum Einsatz. Der Siedepunkt des Dampfphasen-Materials kann über die Kettenlänge der Kohlenwasserstoffe eingestellt werden.

Das bekannte Verfahren und seine Varianten weisen jedoch auch Nachteile auf. Der Durchsatz einer entsprechenden Vorrichtung ist in der Regel aufgrund der notwendigen Vorheiz- und Kondensationsphase gering. Eine bauteilgerechte Aufheizkurve ist nicht oder nur sehr schwierig zu erreichen. Eine ortsspezifische Vorwärmung, also eine individuelle Auf- oder Nachheizung eines oder mehrere Bauteile, ist praktisch nicht möglich. Speziell großflächige, wärmeempfindliche Bauteile laufen herkömmlich Gefahr zu große Energiemengen aufzunehmen, wodurch sie unbrauchbar werden können. Beispielsweise kann es zu Schäden an großen Flüssigkeitskondensatoren kommen.

Aufgabe der vorliegenden Erfindung ist es, ein Lötverfahren und eine Vorrichtung zum Dampfphasenlöten zur Verfügung zu stellen, das die Nachteile des Standes der Technik zumindest zum Teil beseitigt und eine gezielte Wärmezufuhr in der Vorwärm- und/oder Lötphase ermöglicht.

Verfahrensseitig wird die gestellte Aufgabe dadurch gelöst, dass in der Vorwärm- und/oder Lötphase ein Dampfphasenmaterial als Dampf oder als Dampf-Gas-Gemisch auf eine Leiterplatte oder auf andere zu lötende Baugruppen gesteuert aufgebracht wird. Durch das gesteuerte Aufbringen wird die Dosierung des Dampfphasen-Materials besser den Erfordernissen der Leiterplatte und den Erfordernissen des Lötprozesses angepasst. Beim Einsatz eines Dampf-Gas-Gemisches kann die Kondensatmenge nicht nur über die Dauer des Aufbringens, sondern auch über das Verhältnis zwischen Dampf und Gas im Dampfphasen-Material gesteuert werden. Der Gasanteil dient bei Verwendung von Inertgas der Verbesserung der Inertisierung der Leiterplatte. Das Dampf-Gas-Gemisch kann für bestimmte Anwendungen auch 100% Gas und keinen Dampf enthalten. Beispielsweise ist es von Vorteil mit Hilfe von reinem Inertgas einen bereits kondensierten Flüssigkeitsfilm auf der Leiterplatte zu verdrängen, je nach Erfordernis z.B. noch in der Vorwärmphase ganz oder teilweise zu verdrängen, um so die örtlich begrenzt eingetragene Energiemenge zu beeinflussen. Dabei kann über das aufgebrachte Gas z.B. sogar ein kurzzeitiger Kühleffekt erreicht werden, falls das für eine Anwendung gewünscht ist. Als Inertgas eignet sich beispielsweise Stickstoff. Als zweite Wirkung kann das Inertgas zusätzlich zur Inertisierung jener Bereiche beim Dampfphasenlöten dienen, die nicht oder nur teilweise durch das inerte Dampfphasen-Material abgedeckt werden.

Neben Stickstoff haben sich auch folgende Gase als geeignet erwiesen, einen positiven Effekt auf das Dampfphasenlöten auszuüben: Kohlendioxid, Argon, Helium, Wasserstoff und CF4. Auch andere inerte Gase oder auch gezielt chemisch aktive Gase (z.B. Reduktionsgase) können bei Bedarf eingesetzt werden.

Bevorzugt wird das Dampfphasen-Material über die Zeiteinheit örtlich in unterschiedlichen Mengen gesteuert aufgebracht. Dabei wird das Dampfphasen-Material und damit die Energiemenge über die Zeiteinheit örtlich in unterschiedlicher Menge aufgetragen. Dies führt u.a. zu einer exakt definierten Aufheizkurve für die Leiterplatte oder für andere zu lötende Baugruppen, wobei je nach Beschaffenheit, Ausstattung und Konstruktion der Leiterplatte oder Baugruppen einige Bereiche besonders schonend und andere Bereiche besonders schnell aufgeheizt werden können. Mit dem erfindungsgemäßen Verfahren kann somit z.B. jede beliebige Vorheizkurve realisiert werden, wodurch sich die Prozesszeit vorteilhaft verkürzen läßt.

Besonders bevorzugt wird das gesteuerte Aufbringen des Dampfphasen-Materials mit Hilfe einer Aufbringvorrichtung, wie beispielsweise einer Düse, durchgeführt. Das Dampfphasen-Material wird z.B. über eine Düse, eine Spritzpistole, eine Lanze oder allgemeine über einen Injektor aufgebracht. Eine derartige Aufbringvorrichtung kann für bestimmte Anwendungen verfahrbar ausgebildet sein, so dass sich eine Relativbewegung zwischen der Leiterplatte und der Aufbringvorrichtung ergibt. Alternativ oder zusätzlich kann die Leiterplatte an der Aufbringvorrichtung vorbei bewegt werden.

Mit besonderem Vorteil wird das Dampfphasen-Material mit Hilfe eines Düsenfeldes aufgebracht. Dadurch erweitern sich die Möglichkeiten für ein gesteuertes und gleichzeitiges Aufbringen von örtlich unterschiedlichen Mengen an Dampfphasen-Material nochmals. Der Prozess kann dadurch vorteilhaft weiter beschleunigt werden.

Gemäß einer bevorzugten Weiterbildung der Erfindung wird das Dampfphasen-Material beidseitig auf eine Leiterplatte oder auf andere zu lötende Baugruppen aufgebracht. Dadurch kann z.B. eine erwünschte Temperaturverteilung noch schneller erreicht werden.

Vorrichtungsseitig wird die gestellte Aufgabe dadurch gelöst, dass eine Aufbringvorrichtung zum gesteuerten Aufbringen eines Dampfphasen-Materials auf eine Leiterplatte oder auf andere zu lötende Baugruppen vorgesehen ist.

Bevorzugt ist für die Aufbringvorrichtung eine Steuerung vorgesehen, die eine über die Zeiteinheit örtlich in unterschiedlichen Mengen gesteuerte Aufbringung des Dampfphasen-Materials ermöglicht.

Besonders bevorzugt ist als Aufbringvorrichtung ein Injektor vorgesehen. Dieser kann vorteilhaft beispielsweise als Düse, Spritzpistole oder Lanze ausgebildet sein.

Gemäß einer vorteilhaften Weiterbildung der Erfindung ist als Aufbringvorrichtung ein Düsenfeld vorgesehen. Ebenso kann ein Feld aus mehreren Lanzen oder Spritzpistolen vorgesehen sein.

Eine weitere vorteilhafte Ausgestaltung der Erfindung sieht vor, dass beidseitig der Leiterplatte oder einer anderen zu lötenden Baugruppe je eine Aufbringvorrichtung angebracht ist.

Die vorliegende Erfindung bietet eine ganze Reihe von Vorteilen. Einige davon seien hier nochmal zusammengefasst:

Es können bevorzugte Bereiche, Komponenten u.ä. bedarfsgerecht mit Energie versorgt werden.

Es wird eine gesteuerte, auch bauteilspezifische Aufheizkurve ermöglicht.

Der Durchsatz einer erfindungsgemäßen Lötvorrichtung ist höher als bei einer herkömmlichen Anlage, die Durchlaufzeiten für zu lötende Leiterplatten oder Bauteile werden verkürzt.

Es findet eine gute Inertisierung der Leiterplatten statt, auch in den Randbereichen.

Die Inertisierung kann durch den Einsatz eines Dampf-Inertgas-Gemisches noch weiter verbessert werden. Der Einsatz eines Dampf-Gas-Gemisches ist mit Inertgas daher besonders sinnvoll. Einzelne Anwendungen können jedoch auch den Einsatz eines nicht-inerten Gases sinnvoll erscheinen lassen.

Durch die bereits erwähnte Erhöhung des Durchsatzes und Verkürzung der Durchlaufzeiten wird die Integrierbarkeit des Verfahrens in andere Prozesse deutlich verbessert.

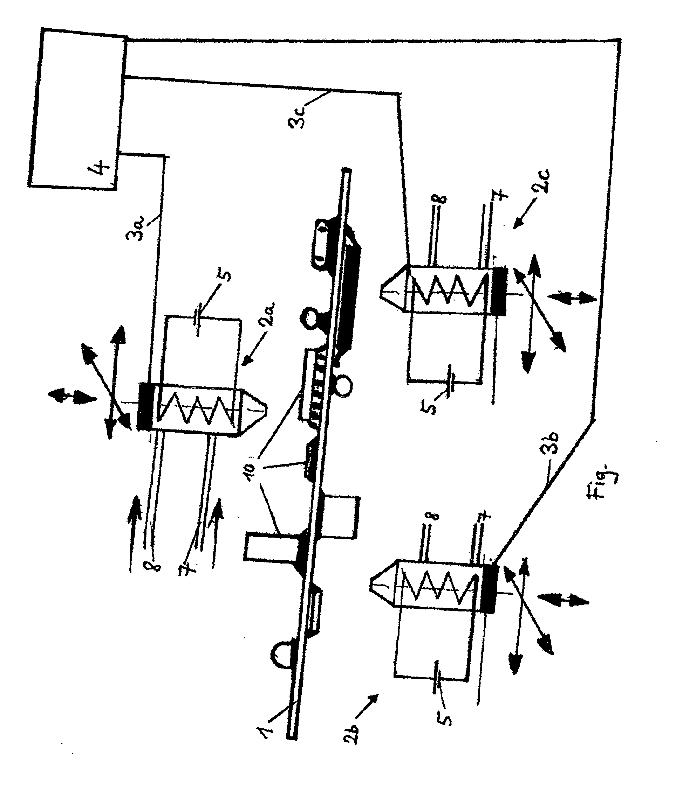

Die Erfindung sowie weitere Ausgestaltungen der Erfindung werden im Folgenden anhand des in der Figur dargestellten Ausführungsbeispiels näher erläutert. Die Figur zeigt eine erfindungsgemäß ausgestattete Lötzone.

Im Einzelnen zeigt die Figur eine Leiterplatte 1, die die zu lötenden Bauteile 10 trägt. Es sind insgesamt drei Aufbringvorrichtungen 2a, b, c zum Aufbringen des Dampfphasenmaterials auf die Leiterplatte 1 gezeigt. Jede der Aufbring-vorrichtungen 2a, b, c ist in diesem Beispiel in alle drei Koordinatenrichtungen verfahrbar ausgebildet und über je eine Steuerleitung 3a, b, c mit einer Steuerung 4 verbunden.

Die Aufbringvorrichtungen 2a, b, c weisen je eine Heizeinrichtung 5 sowie je eine Zufuhreinrichtung 7 für Dampfphasenmaterial und je eine zusätzliche Zufuhreinrichtung 8 für Gas auf. Der Austritt der Aufbringvorrichtung 2a, b, c ist in diesem Beispiel in Düsenform gestaltet.

Die Verfahrbarkeit der Aufbringvorrichtungen 2a, b, c ermöglicht zusammen mit der Steuerung 4 die gewünschte gesteuerte, örtlich in unterschiedlichen Mengen auf die Leiterplatte 1 aufbringbare Zufuhr von Dampfphasenmaterial. Die zusätzliche Gaszufuhr 8 dient der weiteren Differenzierung der Beaufschlagung der Leiterplatte, z.B. wird der zusätzliche Einsatz eines Inertgases vor und/oder nach der eigentlichen Beaufschlagung mit Dampfphasenmaterial ermöglicht.

## Patentansprüche

1. Verfahren zum Dampfphasenlöten mit einer Vorwärm- und einer Lötphase, **dadurch gekennzeichnet, dass** in der Vorwärm- und/oder Lötphase ein Dampfphasenmaterial als Dampf oder als Dampf-Gas-Gemisch auf eine Leiterplatte oder auf andere zu lötende Baugruppen gesteuert aufgebracht wird.

2. Verfahren nach Anspruch 1, **dadurch gekennzeichnet, dass** als Dampfphasenmaterial Kohlenwasserstoffe und/oder Kohlenwasserstoff-GasGemische und/oder lediglich Gase eingesetzt werden, wobei als Gase Inertgase und/oder Wasserstoff und/oder CF4 und/oder gezielt chemisch aktive Gase, wie z. B. Reduktionsgase, eingesetzt werden.

3. Verfahren nach Anspruch 1 oder 2, **dadurch gekennzeichnet, dass** das Dampfphasen-Material über die Zeiteinheit örtlich in unterschiedlichen Mengen gesteuert aufgebracht wird.

4. Verfahren nach einem der Ansprüche 1 bis 3, **dadurch gekennzeichnet, dass** das gesteuerte Aufbringen des Dampfphasen-Materials mit Hilfe einer Aufbringvorrichtung, wie beispielsweise einer Düse, durchgeführt wird.

5. Verfahren nach einem der Ansprüche 1 bis 4, **dadurch gekennzeichnet, dass** das Dampfphasen-Material mit Hilfe eines Düsenfeldes aufgebracht wird.

6. Verfahren nach einem der Ansprüche 1 bis 5, **dadurch gekennzeichnet, dass** das Dampfphasen-Material beidseitig auf eine Leiterplatte oder auf andere zu lötende Baugruppen aufgebracht wird.

7. Vorrichtung zum Dampfphasenlöten mit einer Vorwärm- und einer Lötzone, **dadurch gekennzeichnet, dass** eine Aufbringvorrichtung zum gesteuerten Aufbringen eines Dampfphasen-Materials auf eine Leiterplatte oder auf andere zu lötende Baugruppen vorgesehen ist.

8. Vorrichtung nach Anspruch 7, **dadurch gekennzeichnet, dass** für die Aufbringvorrichtung eine Steuerung vorgesehen ist, die eine über die Zeiteinheit örtlich in unterschiedlichen Mengen gesteuerte Aufbringung des Dampfphasen-Materials ermöglicht.

9. Vorrichtung nach Anspruch 7 oder 8, **dadurch gekennzeichnet, dass** als Aufbringvorrichtung ein Injektor vorgesehen ist.

10. Vorrichtung nach einem der Ansprüche 7 bis 9, **dadurch gekennzeichnet, dass** als Aufbringvorrichtung ein Düsenfeld vorgesehen ist.

11. Vorrichtung nach einem der Ansprüche 7 bis 11, **dadurch gekennzeichnet, dass** beidseitig der Leiterplatte oder einer anderen zu lötenden Baugruppe je eine Aufbringvorrichtung angebracht ist.
